# EUROPÄISCHE PATENTSCHRIFT

(11) **EP 2 109 922 B1**
(45) Veröffentlichungstag und Bekanntmachung des Hinweises auf die Patenterteilung: **28.09.2016**
(21) Anmeldenummer: 08706771.6
(22) Anmeldetag: 18.01.2008
(51) Int. Cl.: H01S 5/34

(54) **UNIPOLARER QUANTENKASKADEN-LASER HOHER EFFIZIENZ**
UNIPOLAR, HIGH EFFICIENCY QUANTUM CASCADE LASER
LASER UNIPOLAIRE À CASCADE QUANTIQUE DE HAUTE EFFICACITÉ

(30) Priorität: 19.01.2007 DE 102007002819
(43) Veröffentlichungstag der Anmeldung: 21.10.2009
(73) Patentinhaber: Fraunhofer-Gesellschaft zur Förderung der angewandten Forschung e.V., 80686 München (DE)
(72) Erfinder: YANG, Quankui, 79194 Gundelfingen (DE); MANZ, Christian, 79100 Freiburg (DE)
(74) Vertreter: Gagel, Roland
(86) Internationale Anmeldenummer: PCT/DE2008/000086
(87) Internationale Veröffentlichungsnummer: WO 2008/086789

(56) Entgegenhaltungen:
- EP-A- 0 964 488
- WO-A-03/023909
- YANG Q ET AL: "GaInAs/AlGaAsSb quantum-cascade lasers" APPLIED PHYSICS LETTERS, AIP, AMERICAN INSTITUTE OF PHYSICS, MELVILLE, NY, Bd. 86, Nr. 13, 22. März 2005 (2005-03-22), Seiten 131109-131109, XP012064794 ISSN: 0003-6951
- GMACHL CLAIRE ET AL: "High-power [lambda] PRG 8 [mu]m quantum cascade lasers with near optimum performance" APPLIED PHYSICS LETTERS, AIP, AMERICAN INSTITUTE OF PHYSICS, MELVILLE, NY, Bd. 72, Nr. 24, 15. Juni 1998 (1998-06-15), Seiten 3130-3132, XP012020423 ISSN: 0003-6951

## Beschreibung

Die vorliegende Erfindung betrifft einen unipolaren Quantenkaskaden-Laser mit mehreren Halbleiter-Mehrschicht-Strukturen, die zwischen zwei Elektroden in periodischer Abfolge so hintereinander geschichtet sind, dass sich jeweils eine für Lichtemission ausgebildete Mehrschicht-Struktur und eine für Elektronentransport ausgebildete Mehrschicht-Struktur abwechseln, wobei die für Lichtemission ausgebildeten Mehrschicht-Strukturen zumindest eine quaternären Materialschicht als Barriereschicht umfassen. Die für Lichtemission ausgebildeten Mehrschicht-Strukturen weisen bei einem derartigen Laser jeweils zumindest ein oberes und ein unteres Energieniveau für Elektronen auf, zwischen denen Licht emittierende Elektronenübergänge stattfinden. Die für Elektronentransport ausgebildeten Mehrschicht-Strukturen ermöglichen jeweils den Elektronentransport aus dem unteren Energieniveaus, der in einer Transportrichtung vorangehenden für Lichtemission ausgebildeten Mehrschicht-Struktur in das obere Energieniveau der in Transportrichtung nachfolgenden für Lichtemission ausgebildeten Mehrschicht-Struktur.

Quantenkaskaden-Laser der genannten Art stellen eine Untergruppe der Halbleiterlaser dar. Sie emittieren im mittleren bis fernen infraroten Wellenlängenbereich, typischerweise im Bereich zwischen 3 und 15 µm. Der Wellenlängenbereich zwischen 3 und 5µm ist für zahlreiche Anwendungen besonders interessant, da beispielsweise die Atmosphäre in diesem Wellenlängenbereich ein Transmissionsfenster aufweist und viele Moleküle bei diesen Wellenlängen eine sehr starke Absorption zeigen.

Quantenkaskaden-Laser sind aus mehreren Halbleiter-Mehrschicht-Strukturen aufgebaut, die zwischen zwei Ansteuerelektroden hintereinander geschichtet sind und einen Wellenleiter für das emittierte Licht bilden. Hierbei wechseln sich jeweils zwei unterschiedlich aufgebaute Mehrschicht-Strukturen ab. Eine für die Lichtemission ausgebildete Mehrschicht-Struktur stellt den in der Regel undotierten aktiven Bereich dar, in dem zumindest ein oberes und ein unteres Energieniveau für Elektronen vorhanden ist, zwischen denen die Licht emittierenden Elektronenübergänge auftreten. Die andere in der Regel teilweise dotierte Mehrschicht-Struktur stellt den so genannten Injektionsbereich dar, durch den Elektronen vom unteren Energieniveau eines benachbarten aktiven Bereiches in das obere Energieniveau des in Transportrichtung der Elektronen des Lasers auf der gegenüberliegenden Seite benachbarten aktiven Bereiches transportiert (und somit dort injiziert) werden. Der Elektronentransport und die. Elektronenübergänge finden bei einem derartigen Laser im Leitungsband der Halbleiter-Mehrschicht-Strukturen statt. Die Mehrschicht-Strukturen bilden dabei eine Potentialleiter von gekoppelten Quantentöpfen, im Folgenden auch als Quantenwells bezeichnet, wobei die Elektronen zwischen den Subbändern der Potentialleiter von einer der Elektroden zur anderen propagieren.

### Stand der Technik

Seit der ersten Realisierung von Quantenkaskaden-Lasern im Jahr 1994 wurden diese Laser ständig weiterentwickelt. So zeigt beispielsweise die US 5 509 025 A einen unipolaren Quantenkaskaden-Laser, bei dem die Mehrschicht-Strukturen mit einer gitterangepassten GaInAs/AlInAs-Materialkombination realisiert sind. Der Leitungsband-Offset beträgt bei einem derartigen Materialsystem jedoch lediglich 0,51 eV, so dass keine ausreichende Sammlung der Ladungsträger erzielbar ist, um eine effiziente Laseremission bei Wellenlängen von ≤ 4 µm zu erreichen.

H. Page et al., "300 K operation of a GaAs-based quantum-cascade laser at λ≈9 µm", Appl. Pyhs Lett. 78, Number 22, Seiten 3529-3531 (2001), beschreibt eine Quantenkaskaden-Laserstruktur mit einem Leitungsband-Offset von 0,39eV.

Eine deutliche Vergrößerung dieses Offset wird erreicht, wenn anstelle von AlInAs gitterangepasstes AlAsSb als Barrierematerial eingesetzt wird. Die Materialkombination GalnAs/AlAsSb ergibt einen Leitungsband-Offset von 1,6 eV. Q. Yang et al., "Room-temperature short wavelength (λ - 3.7-3.9 µm) GaInAs/ AlAsSb quantum cascade lasers", Appl. Pyhs Lett. 88, 121127, Seiten 1-3 (2006), zeigen den Aufbau eines derartigen Quantenkaskaden-Lasers, der bei einer Wellenlänge um 3,7 µm emittiert.

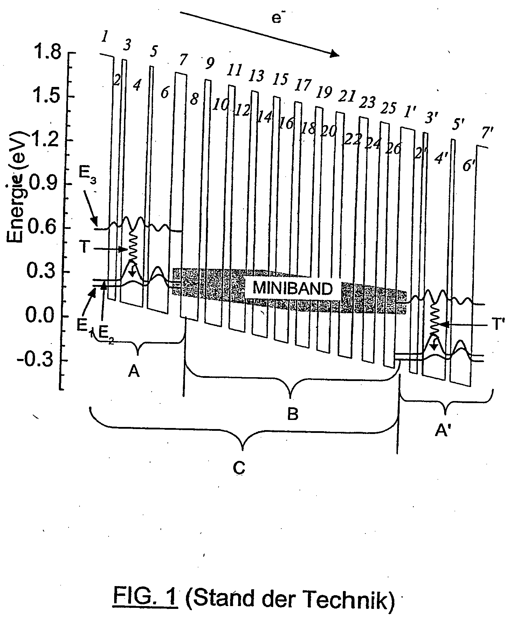

Ein Teil des Leitungsbandprofils dieses Lasers ist schematisch in der Figur 1 dargestellt. In dieser Darstellung die Energie in eV in Abhängigkeit vom Ort in der Schichtstruktur (zwischen den Elektroden) aufgetragen. Quantenkaskaden-Laser setzen sich aus einer Vielzahl von stapelartigen, miteinander verbundenen Halbleiter-Mehrschicht-Strukturen zusammen, die in periodischer Abfolge angeordnet sind. Dabei wird zwischen zwei unterschiedlichen Mehrschicht-Strukturen A, B unterschieden, die sich als zusammenhängende größere Struktur C im Quantenkaskaden-Laser mehrfach wiederholen. Der Bereich A stellt den optisch aktiven Bereich, der Bereich B den Übergangs- oder Injektionsbereich dar. Jede der Mehrschicht-Strukturen A, B besteht aus einer abwechselnden Sequenz von Halbleiterschichten aus unterschiedlichem Material, dem so genannten Barriere-Material wie z.B. AlAsSb und dem so genannten Well-Material wie z.B. GaInAs. Die Schichten mit dem Barriere-Material bilden Potentialbarrieren, die Schichten mit dem Well-Material Quantentöpfe, wie in der Figur 1 ersichtlich ist. Die charakteristische mäanderförmige Bandstruktur dieser Abfolge von Schichten kann ebenfalls der Figur 1 entnommen werden. Bei typischen Quantenkaskaden-Lasern wiederholt sich die in der Figur dargestellte Kombination aus aktivem Bereich A und Übergangsbereich B etwa 30-mal, wobei die gesamten 30 Perioden der Struktur C das Verstärkungsgebiet ergeben.

Der aktive Bereich A weist ein oberes Energie-niveau E₃ auf, das das erlaubte obere Laserniveau darstellt. Der aktive Bereich umfasst im Beispiel der Figur 1 auch zwei niedrigere Energieniveaus E₂ und E₁ für die Elektronen. Die quadratische Wellenfunktion für die Elektronen, die die Aufenthaltswahrscheinlichkeit der Elektronen angibt (Schrödinger-Gleichung), ist für die jeweiligen Zustände bzw. Energieniveaus in der Figur 1 angedeutet. Elektronen, die in das obere Energieniveau E₃ gelangen, relaxieren unter Lichtemission in das untere Energieniveau E₂. Dies erfolgt bei dem dargestellten Laser durch einen vertikalen Übergang T, der in der Figur mit dem wellenförmigen Pfeil angedeutet ist. Dieser vertikale Übergang findet in einem Quantentopf und somit in einer HalbleiterSchicht statt. Das Maximum der Wellenfunktion im oberen Laserniveau E₃ befindet sich daher örtlich an der gleichen Position wie das Maximum im unteren Laser-niveau E₂. Das zusätzliche Energieniveau E₁ unterhalb des unteren Laserniveaus E₂ dient der kontinuierlichen Entleerung des unteren Laserniveaus E₂ mit einer sehr kurzen Relaxationszeit zwischen E₂ und E₁.

Der Übergangsbereich B ist als Übergitter ausgebildet, das als Bragg-Reflektor wirkt und ein Miniband ausbildet, das zumindest teilweise mit den unteren Energieniveaus E₂ und E₁ des in Transportrichtung der Elektronen (vgl. Pfeil über dem Bandschema der Figur 1) unmittelbar vorangehenden aktiven Bereichs A überlappt. Über dieses Miniband erfolgt der, Transport der Elektronen aus dem untersten Energieniveau E₁ der vorangehenden in das obere Energieniveau E₃ des in Transportrichtung der Elektronen nachfolgenden optisch aktiven Bereichs A". Die Elektronen werden somit durch diesen Übergangsbereich B wieder in das obere Laser-niveau E₃ injiziert.

In einer Weiterbildung eines derartigen Quantenkaskaden-Lasers wird ein GaInAs/AlGaAsSb-Materialsystem eingesetzt, das gitterangepasst auf einem InP-Substrat aufgebracht ist. Die Nutzung eines quaternären Materials als Barriereschicht erhöht die Tunnelwahrscheinlichkeit für die Elektronen, so dass die Barriereschichten dicker ausgeführt werden können. Die Funktion der Schichten wird damit unabhängiger von der Qualität der Grenzfläche. Weiterhin ermöglicht der Einsatz quaternärer Schichten eine größere Design-freiheit, da die weite Einstellmöglichkeit des Γ-Tals, Γ-Leitungsband-Offsets von 0,4 eV bis 1,6 eV ermöglichen. Q. Yang et al., "Above room-temperature GaInAs/Al(Ga)AsSb quantum cascade lasers", Phys. Stat. Sol. (c), No. 3, Seiten 415 bis 418 (2006), zeigen den Aufbau eines derartigen gattungsgemäßen Quantenkaskaden-Lasers.

In Q. Yang et al., "GaInAs/ AlGaAsSb quantum cascade lasers", Appl. Pyhs Lett. 86, 131109, Seiten 1-3 (2005), wird ein Quantenkaskaden-Laser beschrieben, der eine Emissionswellenlänge von 4,9µm bei Zimmertemperatur aufweist.

In DE 10 2004 009 531 A1 wird eine Quantenkaskaden-Laserstruktur für Laserwellenlängen zwischen 2,9 und 5,3µm beschrieben, deren Quantentopf- und Barriereschichten derart aufeinander abgestimmt sind, dass sich vorhandene Spannungen innerhalb einer Kaskade weitgehend kompensieren. Das Material mindestens einer Barriereschicht weist,mindestens zwei Materialkomponenten auf.

In WO 03/023909 A wird ein unipolarer Quantenkaskadenlaser offenbart, der zur Verbesserung der Sammlung von Ladungsträgern im optisch aktiven Bereich wenigstens eine Blockadeschicht aufweist.

Im Falle von Quantenkaskaden-Lasern für kleine Wellenlängen von λ ≤ 4 µm werden bei vielen bekannten Materialsystemen Barriereschichten mit hohen Barrieren eingesetzt, um eine ausreichende Sammlung der Elektronen im oberen Laserniveau zu erreichen. Für eine zufriedenstellende Effizienz müssen diese Barriereschichten dann jedoch sehr dünn ausgebildet werden, dies führt wiederum zu Problemen bei der Herstellungsqualität. Durch den Einsatz quaternärer Materialsysteme, wie sie in der vorgenannten Veröffentlichung vorgeschlagen werden, können dickere Schichten verwendet werden, ohne die Effizienz zu verringern. Allerdings liegt die Effizienz der bekannten Quantenkaskaden-Laser noch immer deutlich unterhalb des theoretischen Limits.

Die Aufgabe der vorliegenden Erfindung besteht darin, einen unipolaren Quantenkaskaden-Laser anzugeben, der eine höhere Effizienz aufweist.

### Darstellung der Erfindung

Die Aufgabe wird mit dem Quantenkaskaden-Laser gemäß Patentanspruch 1 gelöst. Vorteilhafte Ausgestaltungen dieses Lasers sind Gegenstand der Unteransprüche oder lassen sich der nachfolgenden Beschreibung sowie dem Ausführungsbeispiel entnehmen.

Der vorgeschlagene unipolare Quantenkaskaden-Laser setzt sich in bekannter Weise aus mehreren Halbleiter-Mehrschicht-Strukturen zusammen, die zwischen zwei Elektroden in periodischer Abfolge so hintereinander geschichtet sind, dass sich jeweils eine für Lichtemission ausgebildete Mehrschicht-Struktur, der so genannte aktive Bereich, und eine für Elektronentransport ausgebildete Mehrschicht-Struktur, der so genannte Übergangs- oder Injektionsbereich, abwechseln. Die für Lichtemission ausgebildeten Mehrschicht-Strukturen weisen jeweils zumindest ein oberes und ein unteres Energieniveau für Elektronen auf, zwischen denen Licht emittierende Elektronenübergänge stattfinden. Die für Elektronentransport ausgebildeten Mehrschicht-Strukturen sind so ausgebildet, dass sie den Elektronentransport aus dem unteren Energieniveau, der in einer Transportrichtung vorangehenden für Lichtemission ausgebildeten Mehrschicht-Struktur in das obere Energieniveau der in Transportrichtung nachfolgenden für Lichtemission ausgebildeten Mehrschicht-Struktur ermöglichen. Die für Lichtemission ausgebildeten Mehrschicht-Strukturen umfassen bei diesem Laser zumindest eine quaternäre Materialschicht als Barriereschicht. Der vorgeschlagene Quantenkaskaden-Laser zeichnet sich dadurch aus, dass die für Lichtemission ausgebildeten Mehrschicht-Strukturen so ausgebildet sind, dass ein höchstes lokales Maximum des Quadrats der quantenmechanischen Wellenfunktion für die Elektronen im oberen Energieniveau in einem Quantentopf auftritt, der der in Transportrichtung vorangehenden für Elektronentransport ausgebildeten Mehrschicht-Struktur am nächsten liegt, dass ein zweithöchstes lokales Maximum des Quadrats der quantenmechanischen Wellenfunktion der Elektronen im oberen Energieniveau in einem zu dem Quantentopf in Transportrichtung benachbarten Quantentopf liegt, dass sich das höchste und das zweithöchste lokale Maximum des Quadrats der quantenmechanischen Wellenfunktion für die Elektronen im oberen Energieniveau um weniger als 50% unterscheiden und dass ein höchstes lokales Maximum des Quadrats der quantenmechanischen Mellenfunktion für die Elektronen im unteren Energieniveau in dem benachbarten Quantentöpf liegt.

In einer bevorzugten Ausführungsform des Quantenkaskaden-Lasers sind die für Lichtemission ausgebildeten Mehrschicht-Strukturen so aufgebaut, dass ein Verhältnis des höchsten lokalen Maximums des Quadrats der quantenmechanischen Wellenfunktion, d.h. der Aufenthaltswahrscheinlichkeit, für die Elektronen im oberen Energieniveau bezogen auf das zweithöchste lokale Maximum des Quadrats der quantenmechanischen Wellenfunktion einen Wert zwischen 105% und 140% aufweist.

In einer weiteren bevorzugten Ausführungsform des Quantenkaskaden-Lasers sind die für Lichtemission ausgebildeten Mehrschicht-Strukturen so aufgebaut, dass ein Verhältnis des höchsten lokalen Maximums des Quadrats der quantenmechanischen Wellenfunktion, d.h. der Aufenthaltswahrscheinlichkeit, für die Elektronen im oberen Energieniveau bezogen auf das zweithöchste lokale Maximum des Quadrats der quantenmechanischen Wellenfunktion einen Wert zwischen 105% und 120% aufweist.

In diesem Zusammenhang ist zu berücksichtigen, dass die Entwicklung von Quantenkaskaden-Lasern rechnergestützt erfolgt, wobei der Schichtaufbau für die gewünschte Emissionswellenlänge durch Simulationsrechnungen ermittelt wird. An dieser Stelle können die Wellenfunktionen bzw. die Quadrate der Wellenfunktionen durch den Schichtaufbau (Material, Dotierung und Dicke der Schichten) beeinflusst werden. Aus den Simulationen werden dann die geeigneten Schichtdicken bzw. Schichtkombinationen für den Aufbau des Lasers erhalten.

Die quantenmechanische Wellenfunktion bzw. die Aufenthaltswahrscheinlichkeit der Elektronen im oberen Laserniveau ist also so gewählt, dass sie einerseits ein Maximum (höchstes lokales Maximum) abseits, an einem anderen Ort im Raum, des Maximums der Wellenfunktion der Elektronen im unteren Laserniveau aufweist. Dies bewirkt eine Erhöhung der Kopplungseffizienz, mit der die Elektronen aus dem Injektionsbereich in den aktiven Bereich einkoppeln, und eine Erhöhung der Lebensdauer des oberen Laserzustands, insbesondere im Vergleich zu Quantenkaskaden-Laserstrukturen, deren Maxima der Elektronen-Wellenfunktionen im selben Quantentopf liegen und bei denen ausschließlich vertikale Übergänge stattfinden.

Andererseits weist die quantenmechanische Wellenfunktion bzw. die Aufenthaltswahrscheinlichkeit der Elektronen im oberen Laserniveau einen starken räumlichen Überlapp mit der quantenmechanischen Wellenfunktion bzw. der Aufenthaltswahrscheinlichkeit der Elektronen im unteren Laserniveau auf (zweithöchstes lokales Maximum), so dass sich eine höhere Effizienz für strahlende Übergänge der Elektronen ergibt. Diese ist insbesondere im Vergleich zu konventionellen Quantenkaskaden-Laserstrukturen mit diagonalen Übergängen zwischen benachbarten Quantentöpfen verbessert, bei denen zur Erhöhung der Lebensdauer des oberen Laserzustands, und damit zur Erreichung der für die Lasertätigkeit notwendigen Besetzungsinversion der Laserzustände, der räumliche Überlapp der quantenmechanischen Wellenfunktionen innerhalb eines Quantentopfes möglichst klein gehalten wird.

Durch die Kombination der quaternären Materialschichten mit der erfindungsgemäßen Ausgestaltung der quantenmechanischen Wellenfunktion wird eine erhebliche Steigerung der externen Quanteneffizienz, der maximalen optischen Leistung und der maximalen Konversionseffizienz von elektrischer Leistung in optische Leistung um einen Faktor zwischen 10 und 20 erreicht.

Mit dem vorgeschlagenen Quantenkaskaden-Laser lässt sich somit eine signifikant erhöhte Effizienz ohne hohe technologische Anforderungen für die Herstellung erreichen, insbesondere für die Erzeugung von Wellenlängen unterhalb von 4 oder 5 µm. Selbstverständlich lassen sich mit der Erfindung auch Quantenkaskaden-Laser realisieren, die bei größeren Wellenlängen emittieren, auch bis in den Terahertz-Frequenzbereich. Der Einsatz von quaternären Materialschichten, die einen großen einstellbaren Bereich der Energiepositionen der Leitungsbandkanten (entweder Γ-Tal oder X-Tal) aufweisen, in Verbindung mit der erfindungsgemäßen Ausgestaltung der quantenmechanischen Wellenfunktion ermöglicht diese deutliche Steigerung der Effizienz. Durch den diagonalen Übergang wird die Injektion der Elektronen in das obere Laser-Niveau erleichtert, da der entsprechende Quantentopf näher am Übergangs- bzw. Injektionsbereich liegt.

In einer bevorzugten Ausgestaltung des Quantenkaskaden-Lasers umfassen hierzu die für die Lichtemission ausgebildeten Mehrschicht-Strukturen zumindest jeweils drei Schichtpaare aus jeweils einer Barriereschicht und einer Quantenwellschicht. Weiterhin sind diese Mehrschicht-Strukturen vorzugsweise so ausgebildet, dass neben dem oberen und dem unteren Energieniveau ein weiteres, tiefer als das untere Energieniveau liegendes Energieniveau vorgesehen ist, in das die Elektronen vom unteren Energieniveau entleert werden können. Die Relaxationszeit muss dabei kürzer sein als die Relaxationszeit aus dem oberen Energieniveau bzw. oberen Laserniveau in das untere Energieniveau bzw. untere Laserniveau. Die Maxima der quadratischen Wellenfunktionen dieser drei Energieniveaus liegen vorzugsweise in drei unterschiedlichen Quantentöpfen.

Weitere vorteilhafte Ausgestaltungen des vorgeschlagenen Quantenkaskaden-Lasers ergeben sich durch Ausgestaltungen, wie sie in den in der Beschreibungseinleitung beschriebenen Veröffentlichungen verwirklicht sind. So kann die Kopplung zwischen dem oberen Laserniveau im optisch aktiven Bereich und dem Miniband für den Transport der Elektronen im Übergangsbereich B durch Verbesserung des Überlapps zwischen den Wellenfunktionen der beiden Energieniveaus bzw. -bänder verbessert werden, solange das obere Laserniveau durch Anlegen eines elektrischen Kontrollfeldes auf der gleichen Höhe mit dem Grundzustand des Injektionsbereichs ist.

Weiterhin ist die Abfolge von Mehrschicht-Strukturen vorzugsweise auf einem Substrat aufgebrächt. Dieses Substrat kann beispielsweise aus Indiumphosphid (InP), aus Galliumarsenid (GaAs), aus Indiumarsenid (InAs) oder aus Galliumantimonid (GaSb) bestehen. Die Materialschichten für die Quantentöpfe sind vorzugsweise aus InGaAs gebildet, während die Barriereschichten vorzugsweise aus AlGaAsSb, aus AlGaInAs, aus GaInAsSb oder aus AlGaInSb bestehen.

Vorzugsweise ist der Übergangsbereich so ausgebildet, dass die Schichtstruktur ein Beugungsgitter mit einem Gitterabstand (Pitch) bildet, der einem Vielfachen der halben Wellenlänge des emittierten Lichtes entspricht. In einer Weiterbildung sind zwei optische Confinement-Schichten auf jeder Seite des Verstärkungsgebietes angeordnet, die das emittierte Licht führen und identische Gitterparameter wie das Substrat aufweisen.

Vorzugsweise wird eine Materialkombination mit einem hohen Offset des Leitungsbandes von ≥ 1,0 eV im aktiven Bereich eingesetzt, während im Übergangsbereich ein Material mit einem geringeren Leitungsband-Offset verwendet wird. Im aktiven Bereich kann hierbei als Quantenwell-Material InGaAs und als Material für die Barriereschicht AlInAs, GaAs, AlGaInAs, GaInAsSb oder AlGaInSb eingesetzt werden. Im Übergangsbereich wird vorzugsweise das Barrierematerial aus den Materialien AlGaInAs, GaInAsSb oder AlGaInSb ausgewählt.

Die Gitterparameter der Quantenwell- und Barriereschichten sind vorzugsweise so gewählt, dass die Gitterparameter einer von beiden Schichten größer und die der anderen Schicht kleiner als die Gitterparameter des Substrates sind.

Die typischen Schichtdicken für die Quantenwell- bzw. Barriereschichten liegen zwischen 0,1 und 10nm.

### Kurze Beschreibung der Zeichnungen

Der vorgeschlagene unipolare Quantenkaskaden-Laser wird nachfolgend anhand eines Ausführungsbeispiels in Verbindung mit den Zeichnungen nochmals näher erläutert. Hierbei zeigen:
- Fig. 1: ein Energiebandschema eines Quantenkaskaden-Lasers gemäß dem Stand der Technik;
- Fig. 2: ein Beispiel für ein Energiebandschema des Quantenkaskaden-Lasers gemäß der vorliegenden Erfindung;
- Fig. 3: den Abstimmbereich der Energieposition des Γ-Tals für AlGaAsSb quaternäres Material;
- Fig. 4a: ein Beispiel für die Lichtausgangsleistung eines Quantenkaskaden-Lasers gemäß dem Stand der Technik;
- Fig. 4b: ein Beispiel für die Konversionseffizienz eines Quantenkaskaden-Lasers gemäß dem Stand. der Technik;
- Fig. 5a: ein Beispiel für die Lichtausgangsleistung des vorgeschlagenen Quantenkaskaden-Lasers;
- Fig. 5b: ein Beispiel für die Konversionseffizienz des vorgeschlagenen Quantenkaskaden-Lasers; und
- Fig. 6: Beispiele für normalisierte Emissionsspektren des vorgeschlagenen Quantenkaskaden-Lasers bei unterschiedlichen Temperaturen.

### Wege zur Ausführung der Erfindung

Das Energiebandschema der Figur 1 eines bekannten Quantenkaskaden-Lasers des Standes der Technik wurde bereits in der Beschreibungseinleitung näher erläutert. Die nachfolgende Tabelle 1 zeigt die bei diesem Laser für die einzelnen Schichten 1 bis 26 gewählten Materialien und Schichtdicken. Die Quantenwell-Schichten sind dabei mit geraden Zahlen, die Barriereschichten mit ungeraden Zahlen bezeichnet. Bei einem derartigen Laser müssen die Barrieren ausreichend hoch gewählt werden, um die für eine Laseremission erforderliche Sammlung der Ladungsträger zu erreichen. Ein effizienter Betrieb erfordert dann wiederum relativ dünne Barriereschichten, die bei der Herstellung Probleme bereiten können.

**Tabelle 1**

| **Referenz** | **Nummer** | **Material** | **Dotierstoff** | **Dotierung [cm⁻³]** | **Dicke** |
|---|---|---|---|---|---|
| Aktiver Bereich / Verstärkungsbereich (A) | 1 (Injektions-barriere) | AlAsSb | | | 2,5 nm |
| | 2 | GaInAs | | | 1,4 nm |
| | 3 | AlAsSb | | | 0,8 nm |
| | 4 | GaInAs | | | 3,7 nm |
| | 5 | AlAsSb | | | 0,7 nm |
| | 6 | GaInAs | | | 3,6 nm |
| | 7 | AlAsSb | | | 2,0 nm |
| Injektions- / Übergangsbereich (B) | 8 | GaInAs | | | 2,9 nm |
| | 9 | AlAsSb | | | 1,1 nm |
| | 10 | GaInAs | | | 2,8 nm |
| | 11 | AlAsSb | | | 1,2 nm |
| | 12 | GaInAs | | | 2,7 nm |
| | 13 | AlAsSb | | | 1,2 nm |
| | 14 | GaInAs | | | 2,6 nm |
| | 15 | AlAsSb | | | 1,2 nm |
| | 16 | GaInAs | | | 2,4 nm |
| | 17 | AlAsSb | | | 1,2 nm |
| | 18 | GaInAs | Si | 3x10¹⁷ | 2,3 nm |
| | 19 | AlAsSb | | | 1,3 nm |
| | 20 | GaInAs | Si | 3x10¹⁷ | 2,2 nm |
| | 21 | AlAsSb | | | 1,4 nm |
| | 22 | GaInAs | Si | 3x10¹⁷ | 2,1 nm |
| | 23 | AlAsSb | | | 1,5 nm |
| | 24 | GaInAs | Si | 3x10¹⁷ | 2,0 nm |
| | 25 | AlAsSb | | | 1,6 nm |
| | 26 | GaInAs | | | 1,9 nm |

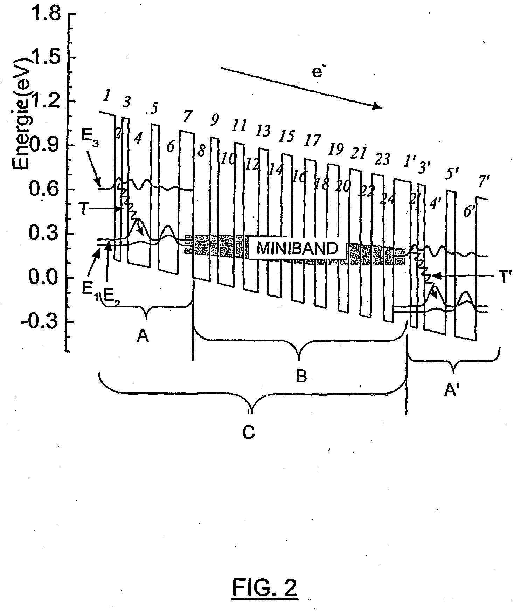

Figur 2 zeigt ein Beispiel für ein Energiebandschema des vorgeschlagenen Quantenkaskaden-Lasers. Auch hier sind die Barriereschichten mit ungeraden und die Quantenwell-Schichten mit geraden Zahlen bezeichnet.

Ein wesentliches Merkmal dieses Quantenkaskaden-Lasers besteht in der besonderen Ausgestaltung der quantenmechanischen Wellenfunktion für die Elektronen im oberen Energieniveau. In Verbindung mit der Wahl von quaternären Barriereschichten wird eine deutlich höhere Effizienz der Lasertätigkeit erreicht. Das Maximum der quadratischen Wellenfunktion im oberen Laserniveau E₃ liegt dabei in der schmalen Quantenwell-Schicht 2 bzw. 2' unmittelbar neben dem Injektionsbereich B. Dies verbessert die Kopplung zwischen dem Grundzustand des Übergangs bzw. Injektorbereichs und dem oberen Laserniveau E₃ des aktiven Bereichs, um eine hohe Injektionseffizienz zu erreichen.

Die Nutzung einer erfindungsgemäßen Ausgestaltung der quantenmechanischen Wellenfunktion, bei der neben den üblichen vertikalen Übergängen diagonale Übergänge in entsprechendem Maße wahrscheinlich sind, zur Erhöhung der Effizienz des Lasers ist bisher bei Quantenkaskaden-Lasern nicht bekannt. In der Regel wird ein vertikaler Übergang realisiert, wie dies beispielsweise auch bei den in der Beschreibungseinleitung genannten Veröffentlichungen von Q. Yang et al. der Fall ist. Die weitere angeführte Veröffentlichung, die US 5509025 A, zeigt zwar in einer Ausgestaltung ebenfalls einen diagonalen Übergang, der jedoch die Lebensdauer des oberen Laserzustandes verlängern soll. Bei der Ausgestaltung dieser Druckschrift wird daher der Überlapp zwischen der quadratischen Wellenfunktion des oberen Laserzustandes und der quadratischen Wellenfunktion des unteren Laserzustandes verringert. Dies führt insbesondere dazu, dass das zweithöchste lokale Maximum der quadratischen Wellenfunktion im oberen Laserzustand E₃ bei dem Quantenkaskaden-Laser dieser Druckschrift weit unterhalb von 50 Prozent der Amplitude des höchsten lokalen Maximums liegt (ca. 10%). Eine Erhöhung der Effizienz dieses Lasers wird dadurch weder erreicht, noch wird einem Fachmann ein Hinweis auf eine Erhöhung der Effizienz durch eine derartige Maßnahme gegeben.

Demgegenüber liegt beim Quantenkaskaden-Laser des vorliegenden Beispiels das zweithöchste lokale Maximum der quadratischen Wellenfunktion im oberen Laserniveau E₃ deutlich oberhalb von 50 Prozent(ca. 90%) des höchsten lokalen Maximums, um eine möglichst effiziente Betriebsweise zu erhalten. Bezogen auf das zweithöchste lokale Maximum hat das höchste lokale Maximum einen Wert von ca. 111%. Weiterhin ist der Übergangsbereich B so ausgebildet, dass die Kopplung zwischen dem unteren Miniband (schattierter Bereich in Figur 2) und dem oberen Laserniveau E₃' ausreichend groß ist und die Elektronentunnelwahrscheinlichkeit in der Kaskadenstruktur verbessert ist.

Ein weiteres wesentliches Merkmal des dargestellten Quantenkaskaden-Lasers besteht im Einsatz quaternärer Materialien als Barriereschichten. In diesem Beispiel wird Gallium in die AlAsSb-Barriereschicht eingebaut, um die Tunnelwahrscheinlichkeit für die Elektronen zu erhöhen. In dem Quantenkaskaden-Laser des Standes der Technik, wie er in Figur 1 dargestellt ist, liefern die GaInAs/AlAsSb-Heterostrukturen einen Leitungsband-Offset (Barrierenhöhe) von 1,6 eV an der direkten Bandlücke. Diese Barrierenhöhe ist für den Aufbau einer ausreichenden Elektronenkonzentration bei kurzwelligen Quantenkaskaden-Lasern erforderlich. Für eine ausreichende Tunnelwahrscheinlichkeit der Elektroden müssen diese Barriereschichten dann jedoch sehr dünn ausgebildet werden. Mit der beim vorliegenden Quantenkaskaden-Laser realisierten Nutzung von quaternären Barriereschichten, insbesondere AlGaAsSb, wird die Tunnelwahrscheinlichkeit für die Elektronen erhöht, so dass die Schichten dicker ausgebildet werden können. Die niedrigere Barriere ist in der Figur 2 im Vergleich zu Figur 1 deutlich zu erkennen. Ein weiterer Vorteil der Einbindung von Gallium in die AlAsSb-Schicht besteht in dem reduzierten mittleren Aluminiumgehalt der Struktur und damit einer verringerten Wahrscheinlichkeit vorzeitiger Degradation der Schichtstrukturen in Luft.

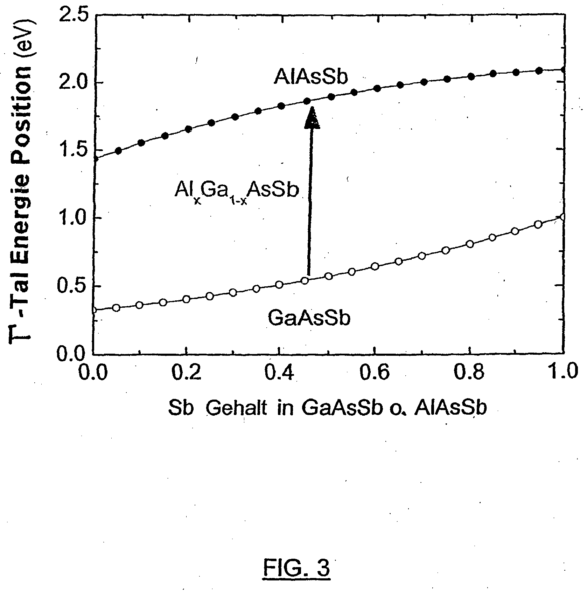

Die Nutzung quaternärer Materialschichten ermöglicht auch eine größere Design-Freiheit bei der Entwicklung des Quantenkaskaden-Lasers, da diese Materialschichten einen breiten Einstellbereich der energetischen Position des Γ-Tals einer AlₓGa₁₋ₓAs_{1-y}Sb_{y} Kombination aufweisen. Die Einstellmöglichkeit dieser energetischen Position ist in dem Diagramm der Figur 3 dargestellt. Der Γ-Leitungsband-Offset kann zwischen AlGaAsSb und GaInAs im Bereich zwischen 0,4 eV und 1,6 eV eingestellt werden. In der Darstellung der Figur 3 wurde die Referenz-Nullenergie-Position an die obere Kante des Valenzbandes von InSb gelegt.

In dem vorliegenden Beispiel wird die Schicht aus Al_{0,62}Ga_{0,38}AsSb gewählt, wobei dann die korrespondierende Barrierenhöhe bei 1,0 eV liegt, und somit um 0,6 eV niedriger als die des in der Figur 1 dargestellten Lasers des Standes der Technik.

In dem vorgestellten Beispiel liegt das Maximum des Quadrates der Wellenfunktion im oberen Laserniveau E₃ in einem schmalen Quantenwell 2 (1,2 nm Dicke) unmittelbar neben dem Injektionsbereich B. Dies verbessert die Kopplung zwischen dem Grundminiband des Übergangs- bzw. Injektorbereichs B und dem oberen Laserniveau im aktiven Bereich, so dass eine erhöhte Injektionseffizienz erreicht wird. Das untere Laserniveau E₂ ist hauptsächlich in einem breiteren Quantenwell 4 (3,7 nm Dicke) zentriert und über eine 1 nm dicke Barriere 3 mit dem schmalen Quantenwell 2 gekoppelt. Das Beispiel zeigt, dass trotz des leicht diagonalen Übergangs noch eine starke Überlappung zwischen den Wellenfunktionen des oberen und des unteren Laserniveaus aufrechterhalten werden kann. Daraus resultiert ein ausreichend großer Wert des Dipolmatrixelementes des optischen Übergangs von 1,1 nm bei Betrieb mit einem elektrischen Feld von F = 90 kV/cm. Die berechneten Lebensdauern der optischen Phononenstreuung betragen τ₃₁ = 5,07 ps und τ₃₂ = 2,99 ps. Das untere Energieniveau E₁ ist so ausgebildet, dass es etwa um den Energiebetrag eines longitudinalen optischen Phonons unterhalb des unteren Energieniveaus E₂ liegt, um diesen unteren Laser-Zustand schnell entleeren zu können. Die Lebensdauer τ₂₁ dieses Übergangs liegt nur bei etwa 0,43 ps, d.h. sehr weit unterhalb der Lebensdauer des oberen Laserzustandes von τ₃₂ = 2,99 ps. Dies stellt die für die Lasertätigkeit erforderliche Besetzungsinversion zwischen dem oberen und dem unteren Laserniveau sicher. Die Emissionswellenlänge des hier beispielhaft angeführten Quantenkaskaden-Lasers liegt bei λ = 3,7 µm.

**Tabelle 2**

| **Referenz** | **Nummer** | **Material** | **Dotierstoff** | **Dotierung [cm⁻³]** | **Dicke** |
|---|---|---|---|---|---|
| Aktiver Bereich/ Verstärkungsbere ich (A) | 1 (Injektionsbarriere | AlGaAsSb | | | 2,8 nm |
| | 2 | GaInAs | | | 1,2 nm |
| | 3 | AlGaAsSb | | | 1,1 nm |
| | 4 | GaInAs | | | 3,7 nm |
| | 5 | AlGaAsSb | | | 1,4 nm |
| | 6 | GaInAs | | | 3,5 nm |
| | 7 | AlGaAsSb | | | 2,2 nm |
| Injektions- / Übergangsbereich (B) | 8 | GaInAs | | | 2,9 nm |
| | 9 | AlGaAsSb | | | 1,4 nm |
| | 10 | GaInAs | | | 2,7 nm |
| | 11 | AlGaAsSb | | | 1,5 nm |
| | 12 | GaInAs | | | 2,5 nm |
| | 13 | AlGaAsSb | | | 1,6 nm |
| | 14 | GaInAs | | | 2,3 nm |
| | 15 | AlGaAsSb | | | 1,7 nm |
| | 16 | GaInAs | Si | 3x10¹⁷ | 2,1 nm |
| | 17 | AlGaAsSb | | | 1,8 nm |
| | 18 | GaInAs | Si | 3x10¹⁷ | 1,9 nm |
| | 19 | AlGaAsSb | | | 1,9 nm |
| | 20 | GaInAs | Si | 3x10¹⁷ | 1,8 nm |
| | 21 | AlGaAsSb | | | 1,9 nm |
| | 22 | GaInAs | Si | 3x10¹⁷ | 1,7 nm |
| | 23 | AlGaAsSb | | | 2,0 nm |
| | 24 | GaInAs | | | 1,7 nm |

Tabelle 2 führt die Materialien und Schichtdicken dieses Lasers im Detail an, die den optisch aktiven Bereich A und den Übergangsbereich bzw. Injektionsbereich B bilden. Die Gesamtstruktur C aus diesen beiden Bereichen wird 30-mal hintereinander geschaltet, um den Vergleich mit dem Quantenkaskaden-Laser des Standes der Technik (Figur 1) zu erreichen. Die dreißig Perioden der Gesamtstruktur bilden die Gewinnzone des Quantenkaskadenlasers.

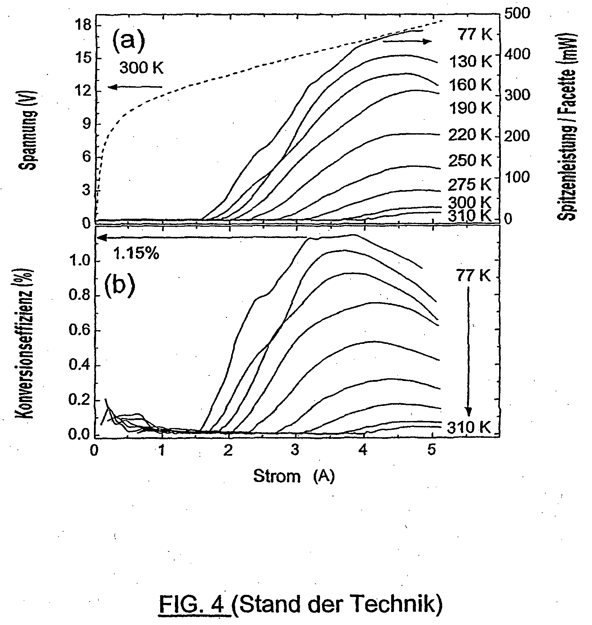

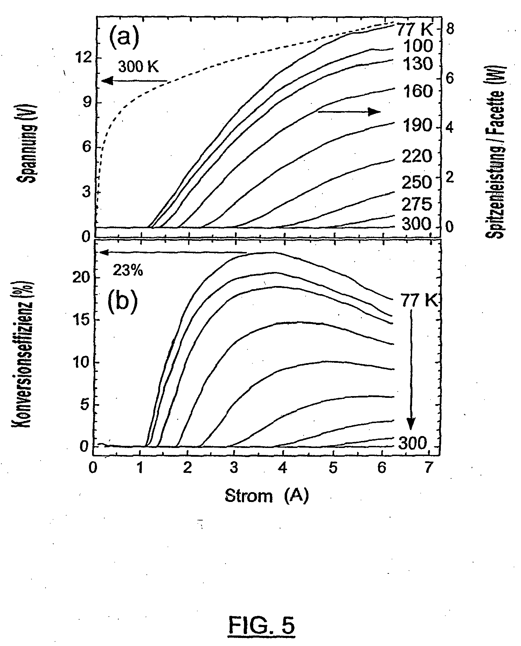

Die Figuren 4 und 5 zeigen entsprechende Vergleichsmessungen an den beiden Lasern. Für den direkten Vergleich des in diesem Beispiel vorgeschlagenen Quantenkaskaden-Lasers mit dem Quantenkaskaden-Laser der Figur 1 und Tabelle 1 wurde eine identische Anzahl von 30 Perioden von Halbleiter-Mehrschichtstrukturen auf einem InP Grundsubstrat hergestellt. Nach der Herstellung dieser Laser und der Kontaktierung der entsprechenden Kontaktierungselektroden wurden die Laser mit Strompulsen mit einer Pulsdauer von 100 ns und einer Repetitionsrate von 1 kHz betrieben. Das von den Lasern emittierte Licht wurde mit einem außeraxialen Parabolspiegel mit f/1,6 kollimiert und entweder in ein Fouriertransformations-Spektrometer, das mit einem thermoelektrisch gekühlten Quecksilber-Kadmium-Tellurit-Detektor und einer Boxcar-Elektronik zur Aufzeichnung des Laserspektrums ausgestattet war, oder auf einen kalibrierten pyroelektrischen Detektor für Raumtemperatur zur Durchführung der direkten Leistungsmessungen fokussiert.

Figur 4a zeigt hierbei die gemessene Lichtleistung in Abhängigkeit vom Injektionsstrom bei dem Laser der Figur 1 mit einer Größe von 14 µm x 3,0 mm bei unterschiedlichen Kühlkörpertemperaturen. Aus dieser Figur ist auch die Spannungs-Strom-Charakteristik bei 300 K ablesbar. Die maximale Spitzenleistung je Facette des Lasers beträgt ca. 31 mW bei 300 K. Die Anstiegseffizienz des Lasers, wenn lediglich die Lichtemission einer Facette betrachtet wird, beträgt 197 mW/A und 33 mW/A bei 77 K bzw. 300 K. Diese Werte sind äquivalent einer externen Quanteneffizienz von 118% bei 77 K und 21% bei 300 K, berechnet gemäß ηD=(2e/hv)(∂P/∂I), wobei e die Elektronenladung, hv die Photonenenergie und ∂P/∂I die Anstiegseffizienz bezeichnen.

Figur 4b zeigt die gemessene temperaturabhängige gesamte Konversionseffizienz von elektrischer zu optischer Leistung als Funktion des Injektionsstroms des genannten Lasers des Standes der Technik. Unter der gesamten Konversionseffizienz ist hierbei zu verstehen, dass die Lichtemission von beiden Facetten gemessen wurde. Die maximale Konversionseffizienz beträgt lediglich 1,15% bei 77 K.

Im Vergleich dazu zeigen die Figuren 5a und 5b die Messungen bei dem hier vorgeschlagenen Quantenkaskaden-Laser mit einer Größe von 18 µm x 2,7 mm. Wie diesen Messungen zu entnehmen ist, beträgt die maximale Spitzenleistung pro Facette bei 77 K 8,2 W, während die Konversionseffizienz der Umwandlung der elektrischen in optische Leistung einen Maximalwert von 23,2% erreicht. Die Anstiegseffizienz des Lasers, wenn die Lichtemission von nur einer Facette betrachtet wird, beträgt 2690 mW/A bei 77 K und 113 mW/A bei 300 K. Diese Werte entsprechen einer gesamten externen differentiellen Quanteneffizienz von η_{D} = 1584% bei 77 K oder η_{D} = 69% bei 300 K. Diese Werte liegen bis zu 20-fach höher als die des bekannten Lasers des Standes der Technik.

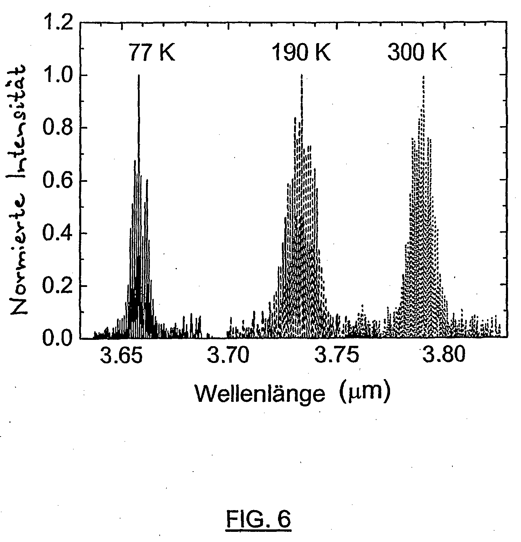

Figur 6 zeigt Emissionsspektren des vorgeschlagenen Quantenkaskaden-Lasers bei Kühlkörpertemperaturen von 77 K, 190 K und 300 K. Die Emissionswellenlänge des Lasers liegt bei 3,65 µm, 3,73 µm und 3,79 µm bei den entsprechenden Temperaturen. Die Emissionswellenlängen sind annähernd die gleichen wie bei dem beschriebenen Laser des Standes der Technik (Figur 1, Tabelle 1).

Tabelle 3 fasst die Verbesserungen des vorgeschlagenen Quantenkaskaden-Lasers dieses Ausführungsbeispiels gegenüber dem beschriebenen Quantenkaskaden-Laser des Standes der Technik nochmals zusammen. Aus den Messungen und der Tabelle ist ersichtlich, dass der entsprechend der vorliegenden Erfindung realisierte Laser eine deutlich höhere maximale Ausgangsleistung (17,8-fach höher), eine deutlich höhere externe Quanteneffizienz (13,4-fach höher) und eine deutlich größere Konversionseffizienz (20,2-fach höher) aufweist als der bekannte Laser.

**Tabelle 3**

| **Wert bei 77 K** | **Stand der Technik** | **Erfindung** | **Verbesserungsfaktor** |
|---|---|---|---|
| Emissionswellenlänge [µm] | 3,73 | 3,65 | - |
| Schwellstromdichte [kA/cm²] | 3,90 | 2,38 | 1,64 |
| Maximale Spitzenausgangsleistung [mW] | 460 | 8200 | 17,8 |
| Anstiegseffizienz [mW/A] | 197 | 2690 | 13,7 |
| Gesamte externe | | | |
| Quanteneffizienz [%] | 118 | 1584 | 13,4 |
| Maximale Konversionseffizienz elektrisch → optisch | 1,15 | 23,2 | 20,2 |

Durch die vorliegende Erfindung wird somit ein unipolarer Quantenkaskaden-Laser realisiert, der die folgenden Vorteile aufweist:
- Deutliche Verbesserung der Injektionseffizienz von Elektronen aus dem Miniband des Übergangsbereiches in das obere Laserniveau des aktiven Bereiches. Dies kann die externe Quanteneffizienz deutlich verbessern und die maximale Ausgangsleistung deutlich erhöhen.
- Die Implementierung ein oder mehrerer quaternärer Materialschichten ermöglicht eine größere Freiheit beim Design eines Quantenkaskaden-Lasers aufgrund des breiten Einstellbereiches der Energiepositionen der Bandkanten des quaternären Materials. Damit lassen sich auch Terahertz-Quantenkaskaden-Laser realisieren, bei denen niedrige Barrieren für eine ausreichende Tunnelwahrscheinlichkeit der Elektronen erforderlich sind.
- Durch die zumindest eine quaternäre Barriereschicht mit einem reduzierten Leitungsband-Offset innerhalb der Quantenkaskaden-Struktur können dickere Schichten realisiert werden als mit den bekannten Lasern ohne eine derartige quaternäre Schicht. Damit ist es nicht mehr erforderlich, spezielle Schichtwachstumstechniken wie die Molekularstrahlepitaxie (MBE) für den Schichtaufbau einzusetzen.

### Bezugszeichenliste

- A: optisch aktiver Bereich
- B: Injektions- bzw. Übergangsbereich
- C: Schichtstruktur einer Periode des Lasers
- T: Licht emittierender Übergang

## Patentansprüche

1. Unipolarer Quantenkaskaden-Laser mit mehreren Halbleiter-Mehrschicht-Strukturen, die zwischen zwei Elektroden in periodischer Abfolge so hintereinander geschichtet sind, dass sich jeweils eine für Lichtemission ausgebildete Mehrschicht-Struktur und eine für Elektronentransport ausgebildete Mehrschicht-Struktur abwechseln,
wobei die für Lichtemission ausgebildeten Mehrschicht-Strukturen jeweils zumindest ein oberes und ein unteres Energieniveau für Elektronen aufweisen, zwischen denen Licht emittierende Elektronenübergänge stattfinden, und die für Elektronentransport ausgebildeten Mehrschicht-Strukturen jeweils den Elektronentransport aus dem unteren Energieniveau der in einer Transportrichtung vorangehenden für Lichtemission ausgebildeten Mehrschicht-Struktur in das obere Energieniveau der in Transportrichtung nachfolgenden für Lichtemission ausgebildeten Mehrschicht-Struktur ermöglicht, und
wobei die für Lichtemission ausgebildeten Mehrschicht-Strukturen zumindest eine quaternäre Materialschicht als Barriereschicht umfassen, **dadurch gekennzeichnet,**
**dass** die für Lichtemission ausgebildeten Mehrschicht-Strukturen so aufgebaut sind, dass ein höchstes lokales Maximum des Quadrats der quantenmechanischen Wellenfunktion für die Elektronen im oberen Energieniveau in einem Quantentopf auftritt, der der in Transportrichtung vorangehenden für Elektronentransport ausgebildeten Mehrschicht-Struktur am nächsten liegt, dass ein zweithöchstes lokales Maximum des Quadrats der quantenmechanischen Wellenfunktion der Elektronen im oberen Energieniveau in einem zu dem Quantentopf in Transportrichtung benachbarten Quantentopf liegt, dass sich das höchste und das zweithöchste lokale Maximum des Quadrats der quantenmechanischen Wellenfunktion für die Elektronen im oberen Energieniveau um weniger als 50% unterscheiden und dass ein höchstes lokales Maximum des Quadrats der quantenmechanischen Wellenfunktion für die Elektronen im unteren Energieniveau in dem benachbarten Quantentopf liegt.

2. Quantenkaskaden-Laser nach Anspruch 1,
**dadurch gekennzeichnet,**
**dass** ein Verhältnis des höchsten lokalen Maximums des Quadrats der quantenmechanischen Wellenfunktion für die Elektronen im oberen Energieniveau bezogen auf das zweithöchste lokale Maximum des Quadrats der quantenmechanischen Wellenfunktion einen Wert zwischen 105% und 140% aufweist.

3. Quantenkaskaden-Laser nach Anspruch 2,
**dadurch gekennzeichnet,**
**dass** das Verhältnis einen Wert zwischen 105% und 120% aufweist.

4. Quantenkaskaden-Laser nach einem der Ansprüche 1 bis 3, **dadurch gekennzeichnet,**
**dass** die für Lichtemission ausgebildeten Mehrschicht-Strukturen zumindest drei Schichtpaare aus jeweils einer Barriereschicht und einer Quantenwellschicht umfassen.

5. Quantenkaskaden-Laser nach einem der Ansprüche 1 bis 4, **dadurch gekennzeichnet,**
**dass** die für Lichtemission ausgebildeten Mehrschicht-Strukturen jeweils drei Energieniveaus aufweisen, zwischen denen Elektronenübergänge stattfinden.

6. Quantenkaskaden-Laser nach einem der Ansprüche 1 bis 5, **dadurch gekennzeichnet,**
**dass** die für Elektronentransport ausgebildeten Mehrschicht-Strukturen ein Übergitter bilden, das als Bragg-Reflektor für das emittierte Licht wirkt.

7. Quantenkaskaden-Laser nach einem der Ansprüche 1 bis 6, **dadurch gekennzeichnet,**
**dass** die für Elektronentransport ausgebildeten Mehrschicht-Strukturen ein Beugungsgitter mit einem Gitterabstand bilden, der einem Vielfachen einer halben Wellenlänge des emittierten Lichts entspricht.

8. Quantenkaskaden-Laser nach einem der Ansprüche 1 bis 7, **dadurch gekennzeichnet,**
**dass** die Mehrschicht-Strukturen auf einem Substrat aus InP, GaAs, InAs oder GaSb aufgebracht sind.

9. Quantenkaskaden-Laser nach Anspruch 8,
**dadurch gekennzeichnet,**
**dass** Gitterparameter von Quantenwell- und Barriereschichten so gewählt sind, dass die Gitterparameter einer von beiden Schichttypen größer und die des anderen Schichttyps kleiner als Gitterparameter des Substrates sind.

10. Quantenkaskaden-Laser nach Anspruch 8 oder 9,
**dadurch gekennzeichnet,**
**dass** eine optische Confinement-Schicht auf jeder Seite eines durch die Mehrschicht-Strukturen gebildeten Verstärkungsgebietes des Lasers angeordnet ist, die das emittierte Licht führt und identische Gitterparameter wie das Substrat aufweist.

11. Quantenkaskaden-Laser nach einem der Ansprüche 1 bis 10, **dadurch gekennzeichnet,**
**dass** die Mehrschicht-Strukturen Quantenwellschichten aus InGaAs und Barriereschichten aus AlGaAsSb oder AlGaInAs oder GaInAsSb oder AlGaInSb aufweisen.

12. Quantenkaskaden-Laser nach einem der Ansprüche 1 bis 10, **dadurch gekennzeichnet,**
**dass** die für Lichtemission ausgebildeten Mehrschicht-Strukturen aus einer Materialkombination mit einem Offset des Leitungsbandes von ≥ 1,0 eV und die für Elektronentransport ausgebildeten Mehrschicht-Strukturen aus einer Materialkombination mit einem geringeren Offset des Leitungsbandes aufgebaut sind.

13. Quantenkaskaden-Laser nach Anspruch 12,
**dadurch gekennzeichnet,**
**dass** die für Lichtemission ausgebildeten Mehrschicht-Strukturen Quantenwellschichten aus InGaAs und Barriereschichten aus AlInAs oder GaAs oder AlGaInAs oder GaInAsSb oder AlGaInSb aufweisen, und dass die für Elektronentransport ausgebildeten Mehrschicht-Strukturen Barriereschichten aus AlGaInAs oder GaInAsSb oder AlGaInSb aufweisen.

## Claims

1. A unipolar quantum cascade laser with several semiconductor multilayer structures that are layered behind one another between two electrodes in a periodic sequence such that a multilayer structure designed for light emission and a multilayer structure designed for electron transport respectively alternate,
wherein the multilayer structures designed for light emission respectively feature at least one upper and one lower energy level for electrons, between which electron transitions emitting light take place, and the multilayer structures designed for electron transport respectively allow the electron transport from the lower energy level of the preceding multilayer structure designed for light emission referred to the transport direction into the upper energy level of the following multilayer structure designed for light emission referred to the transport direction, and
wherein the multilayer structures designed for light emission comprise at least one quaternary material layer as barrier layer,
**characterized in**
**that** the multilayer structures designed for light emission are realized in such a way that a highest local maximum of the square of the quantum-mechanical wave function for the electrons in the upper energy level occurs in a quantum well that lies closest to the preceding multilayer structure designed for electron transport referred to the transport direction, in that a second highest local maximum of the square of the quantum-mechanical wave function of the electrons in the upper energy level lies in a quantum well situated adjacent to the quantum well referred to the transport direction, in that the highest and the second highest local maximum of the square of the quantum-mechanical wave function for the electrons in the upper energy level differ by less than 50%, and in that a highest local maximum of the square of the quantum-mechanical wave function for the electrons in the lower energy level lies in said adjacent quantum well.

2. The quantum cascade laser according to Claim 1, **characterized in**
**that** a ratio of the highest local maximum of the square of the quantum-mechanical wave function for the electrons in the upper energy level has a value between 105% and 140% referred to the second highest local maximum of the square of the quantum-mechanical wave function.

3. The quantum cascade laser according to Claim 2, **characterized in**
**that** the ratio has a value between 105% and 120%.

4. The quantum cascade laser according to one of Claims 1 to 3, **characterized in**
**that** the multilayer structures designed for light emission respectively comprise at least three layer pairs that respectively consist of a barrier layer and a quantum well layer.

5. The quantum cascade laser according to one of Claims 1 to 4, **characterized in**
**that** the multilayer structures designed for light emission respectively have three energy levels, between which electron transitions take place.

6. The quantum cascade laser according to one of Claims 1 to 5, **characterized in**
**that** the multilayer structures designed for electron transport form a superlattice that acts as a Bragg reflector for the emitted light.

7. The quantum cascade laser according to one of Claims 1 to 6, **characterized in**
**that** the multilayer structures designed for electron transport form an optical lattice with a pitch that corresponds to a multiple of half the wavelength of the emitted light.

8. The quantum cascade laser according to one of Claims 1 to 7, **characterized in**
**that** the multilayer structures are applied onto a substrate of InP, GaAs, InAs, or GaSb.

9. The quantum cascade laser according to Claim 8, **characterized in**
**that** the lattice parameters of the quantum well layers and the barrier layers are chosen such that the lattice parameters of one of the two layer types are higher and the lattice parameters of the other layer type are lower than the lattice parameters of the substrate.

10. The quantum cascade laser according to Claim 8 or 9, **characterized in**
**that** an optical confinement layer is arranged on each side of the amplification region of the laser that is formed by the multilayer structures, wherein this optical confinement layer guides the emitted light and has the same lattice parameters as the substrate.

11. The quantum cascade laser according to one of Claims 1 to 10, **characterized in**
**that** the multilayer structures feature quantum well layers of InGaAs and barrier layers of AlGaAsSb or AlGaInAs or GaInAsSb or AlGaInSb.

12. The quantum cascade laser according to one of Claims 1 to 10, **characterized in**
**that** the multilayer structures designed for light emission consist of a material combination with an offset of the conduction band of ≥ 1.0 eV and the multilayer structures designed for electron transport consist of a material combination with a lower offset of the conduction band.

13. The quantum cascade laser according to Claim 12, **characterized in**
**that** the multilayer structures designed for light emission feature quantum well layers of InGaAs and barrier layers of AlInAs or GaAs or AlGaInAs or GaInAsSb or AlGaInSb, and in that the multilayer structures designed for electron transport feature barrier layers of AlGaInAs or GaInAsSb or AlGaInSb.

## Revendications

1. Laser à cascade quantique unipolaire avec plusieurs structures multicouches à semi-conducteurs, qui sont stratifiés les unes derrière les autres en séquence périodique entre deux électrodes de telle sorte que respectivement une structure multicouches conçue pour l'émission de lumière et une structure multicouches conçue pour le transport d'électrons alternent, dans lequel les structures multicouches conçues pour l'émission de lumière présentent respectivement au moins un niveau d'énergie élevée et un niveau d'énergie bas pour les électrons, entre lesquels les transitions d'électrons émettant de la lumière ont lieu, et les structures multicouches conçues pour le transport d'électrons permettent respectivement le transport d'électrons du niveau d'énergie inférieur de la structures multicouches conçues pour l'émission de lumière précédente dans la direction de transport au niveau d'énergie supérieur de la structure multicouches conçue pour l'émission de lumière suivante dans la direction de transport, dans lequel les structure multicouches conçues pour l'émission de lumière comprennent au moins une couche de matériau quaternaire comme couche de barrière, **caractérisé en ce que** les structures multicouches conçues pour l'émission de lumière sont structurées de telle sorte qu'un maximum local le plus haut du carré de la fonction d'onde mécanique quantique pour les électrons dans le niveau d'énergie élevé survienne dans un puits quantique, qui est situé le plus près de la structure multicouches conçue pour le transport d'électrons précédente dans la direction de transport, de telle sorte qu'un maximum local deux fois plus haut du carré de la fonction d'onde mécanique quantique des électrons dans le niveau d'énergie élevé se situe dans un puits quantique voisin du puits quantique dans la direction de transport, de telle sorte que le maximum local le plus haut et deux fois plus haut du carré de la fonction d'onde mécanique quantique pour les électrons se différencient de moins de 50 % dans le niveau d'énergie élevée et **en ce que** un maximum local le plus haut du carré de la fonction d'onde mécanique quantique pour les électrons dans le niveau d'énergie bas soit situé dans le puits quantique voisin.

2. Laser à cascade quantique selon la revendication 1, **caractérisé en ce que** un rapport du maximum local le plus haut du carré de la fonction d'onde mécanique quantique pour les électrons dans le niveau d'énergie élevé par rapport au maximum local deux fois plus haut du carré de la fonction d'onde mécanique quantique présente une valeur comprise entre 105 % et 140 %.

3. Laser à cascade quantique selon la revendication 2, **caractérisé en ce que** le rapport présente une valeur comprise entre 105 % et 120%.

4. Laser à cascade quantique selon une des revendications 1 à 3, **caractérisé en ce que** les structures multicouches conçues pour l'émission de lumière comprennent au moins trois paires de couche constituées respectivement d'une couche de barrière et d'une couche de puits quantique.

5. Laser à cascade quantique selon une des revendications 1 à 4, **caractérisé en ce que** les structures multicouches conçues pour l'émission de lumière présentent respectivement trois niveaux d'énergie, entre lesquelles des transitions d'électrons ont lieu.

6. Laser à cascade quantique selon une des revendications 1 à 5, **caractérisé en ce que** les structures multicouches conçues pour le transport d'électrons forment un super réseau, qui fonctionne comme un réflecteur de Bragg pour la lumière émise.

7. Laser à cascade quantique selon une des revendications 1 à 6, **caractérisé en ce que** les structures multicouches conçues pour le transport d'électrons forment un réseau de diffraction avec une distance réticulaire, qui correspond à un multiple d'une demi-longueur d'onde de la lumière émise.

8. Laser à cascade quantique selon une des revendications 1 à 7, **caractérisé en ce que** les structures multicouches sont appliquées sur un substrat constitué de InP, GaAs, InAs ou GaSb.

9. Laser à cascade quantique selon la revendication 8, **caractérisé en ce que** les paramètres de réseau de couche de barrière et de puits quantique sont sélectionnés de telle sorte que les paramètres de réseau d'un des deux types de couche soient plus grands et ceux de l'autre type de couche soient plus petits que les paramètres de réseau du substrat.

10. Laser à cascade quantique selon la revendication 8 ou 9, **caractérisé en ce que** une couche de confinement optique est disposée sur chaque côté d'une zone d'amplification du laser formée par les structures multicouches, qui guide la lumière émise et présente des paramètres de réseau identiques au substrat.

11. Laser à cascade quantique selon une des revendications 1 à 10, **caractérisé en ce que** les structures multicouches présentent des couches de puits quantique constituées de InGaAs et des couches de barrière constituées de AlGaAsSb ou AlGaInAs ou GaInAsSb ou AlGaInSb.

12. Laser à cascade quantique selon une des revendications 1 à 10, **caractérisé en ce que** les structures multicouches conçues pour l'émission de lumière sont constituées d'une combinaison de matériaux avec un décalage de la plage de puissance de ≥ 1,0 eV et les structures multicouches conçues pour le transport d'électrons sont constituées d'une combinaison de matériaux avec un décalage moindre de la plage de puissance.

13. Laser à cascade quantique selon la revendication 12, **caractérisé en ce que** les structures multicouches conçues pour l'émission de lumière présentent des couches de puits quantique constituées de InGaAs et des couches de barrière constituées de AlGaAsSb ou AlGaInAs ou GaInAsSb ou AlGaInSb, et les structures multicouches conçues pour le transport d'électrons présentent des couches de barrière constituées de AlGaInAs ou GaInAsSb ou AlGaInSb.
